# EUROPEAN PATENT APPLICATION

(11) **EP 4 635 335 A1**
(43) Date of publication of application: **22.10.2025**
(21) Application number: 22968537.5
(22) Date of filing: 16.12.2022
(51) Int. Cl.: A24F 40/51

(54) **AEROSOL GENERATION DEVICE**

(71) Applicant: Japan Tobacco Inc., Tokyo 105-6927 (JP)
(72) Inventor: UCHIBORI, Tomoya, Tokyo 130-8603 (JP); MINATO, Junji, Tokyo 130-8603 (JP); YOSHIDA, Ryo, Tokyo 130-8603 (JP); TAGAYA, Shuhei, Tokyo 130-8603 (JP); NAKAMURA, Satoshi, Tokyo 130-8603 (JP)
(74) Representative: Hoffmann Eitle
(86) International application number: PCT/JP2022/046364
(87) International publication number: WO 2024/127627

(57) **Abstract**

An aerosol generation device comprising: a heating unit that heats a base material including an aerosol source, in accordance with a control sequence, via power supply from a power source; a detection unit that detects movement of the comprising device; and a control unit that performs control so as to switch one currently selected control sequence to another control sequence when a specific movement is detected by the detection unit.

## Description

### TECHNICAL FIELD

The present disclosure relates to an aerosol generation device.

### BACKGROUND ART

PTL 1 discloses an aerosol delivery device provided with a motion sensor within a housing, the motion sensor being configured to detect a defined motion of the aerosol delivery device caused by a user interaction with the housing to perform a gesture, and the motion sensor being configured to convert the defined motion into an electrical signal, wherein a microprocessor or the motion sensor is configured to: receive the electrical signal; recognize the gesture and an operation associated with the gesture on the basis of the electrical signal; and control at least one functional element of the aerosol delivery device to perform the operation.

### CITATION LIST

### PATENT LITERATURE

PTL 1 JP 2021-58212 A

### SUMMARY OF INVENTION

### TECHNICAL PROBLEM

In configurations in which a currently selected control sequence is not switched to another control sequence when a motion of the host device itself is detected, it is not easy to switch the control sequence.

The object of the present disclosure is to make it possible to switch control sequences easily.

### SOLUTION TO PROBLEM

The present disclosure provides an aerosol generation device comprising: a heating unit which heats a substrate containing an aerosol source by means of electrical supply from a power source, in accordance with a control sequence; a detecting unit which detects motion of the host device; and a control unit which performs control to switch a currently selected control sequence to another control sequence when a specific motion is detected by the detecting unit.

The control unit may perform control to select the other control sequence from among a plurality of control sequences. In this case, the control unit may perform control to select the other control sequence in accordance with a predetermined order of the plurality of control sequences. Furthermore, the control unit may perform control to select the other control sequence in accordance with the type of the specific motion detected by the detecting unit.

The aerosol generation device may additionally comprise a notification unit which notifies information specifying the other control sequence. In this case, the notification unit may notify the information specifying the other control sequence by vibrating a number of times corresponding to the other control sequence. Furthermore, the notification unit may notify the information specifying the other control sequence by causing a number of light-emitting elements corresponding to the other control sequence to emit light.

The control unit may perform control such that the control sequence is not switched if a prescribed condition is met, even if the specific motion is detected by the detecting unit. In this case, the aerosol generation device may additionally comprise an opening and closing portion which opens or closes an opening through which the substrate is inserted, wherein the prescribed condition is that the opening is opened by the opening and closing portion. Further, the aerosol generation device may additionally comprise an opening and closing portion which opens or closes an opening through which the substrate is inserted, wherein the prescribed condition is that the opening is opened by the opening and closing portion, and the specific motion detected by the detecting unit is a predefined motion.

### ADVANTAGEOUS EFFECTS OF INVENTION

According to the present disclosure, control sequences can easily be switched.

### BRIEF DESCRIPTION OF DRAWINGS

Fig. 1 is a diagram in which a front face side of an aerosol generation device is viewed from diagonally above.
Fig. 2 is a diagram in which an upper face of the aerosol generation device is viewed from above.
Fig. 3 is a diagram schematically illustrating the internal configuration of a main body device.
Fig. 4 is a diagram illustrating a method for sensing a double-tap operation by means of a sensor unit.
Fig. 5 is a diagram illustrating a method for sensing a shake operation by means of the sensor unit.
Fig. 6 is a diagram illustrating a first method for switching the heating profile.
Fig. 7 is a diagram illustrating a second method for switching the heating profile.
Fig. 8 is a flowchart showing a first operation example performed when the aerosol generation device switches between heating profiles.
Fig. 9 is a flowchart showing a second operation example performed when the aerosol generation device switches between heating profiles.

### DESCRIPTION OF EMBODIMENTS

Embodiments of the present disclosure will be described in detail below with reference to the appended drawings. An aerosol generation device according to the embodiments is a form of electronic cigarette. A substance generated by the aerosol generation device is an aerosol. An aerosol is a mixture of minute liquid or solid particles suspended in a gas, and air or another gas. The embodiments describe aerosol generation devices which generate the aerosol without associated burning. Furthermore, the embodiments describe aerosol generation devices to which a solid aerosol source can be fitted.

### «Embodiment 1 »

### <Example of External Appearance>

An example of the external appearance of an aerosol generation device used in Embodiment 1 will first be described.

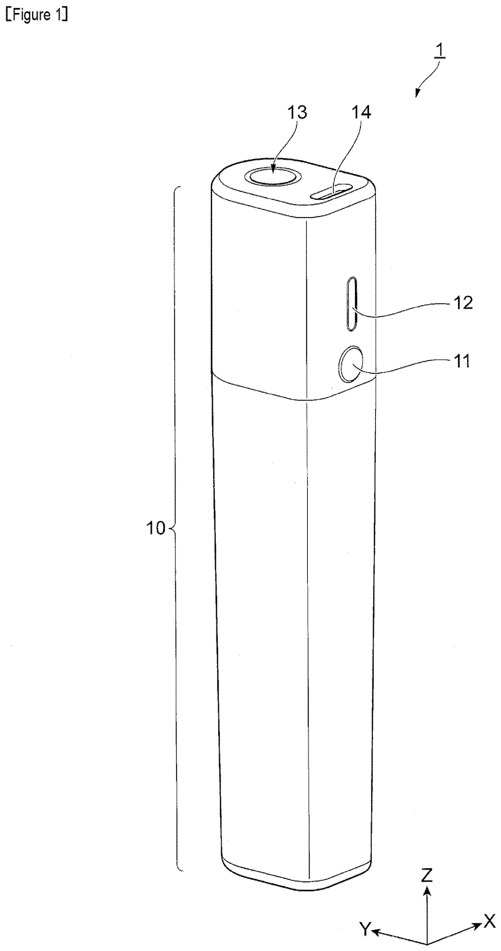

Fig. 1 is a diagram in which a front face side of an aerosol generation device 1 is viewed from diagonally above.

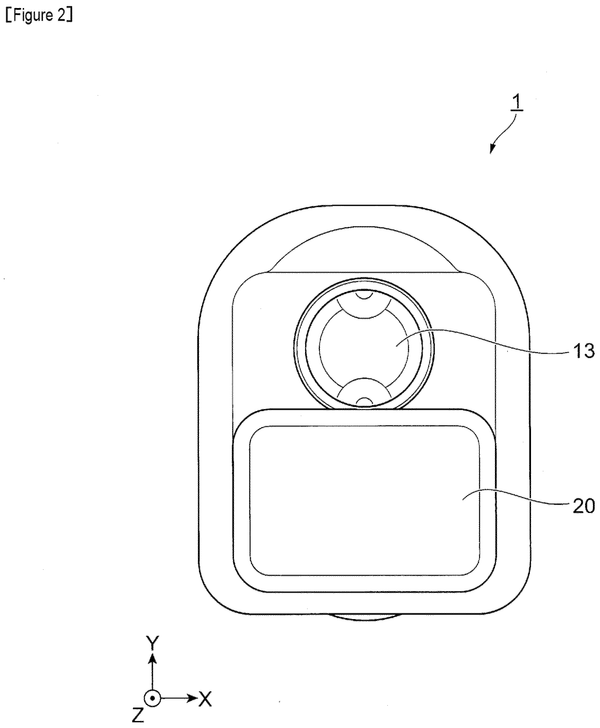

Fig. 2 is a diagram in which an upper face of the aerosol generation device 1 is viewed from above.

The aerosol generation device 1 is configured by a main body device 10, and a slide cover 20 which can be slidably operated along an upper face of the main body device 10. It should be noted that, for convenience of description, fig. 1 shows a state in which the slide cover 20 has been removed from the upper face of the main body device 10.

In the present embodiment, the face on which a power button 11 is provided will be referred to as a "front face". Furthermore, the face on which an insertion port into which a stick-type substrate is inserted (referred to below as a "stick-type substrate insertion port") 13 is provided will be referred to as an "upper face".

Moreover, the face on the opposite side to the upper face will be referred to as the "bottom face", and the other three faces will be referred to as "side faces".

An LED lamp 12 is provided on the front face of the main body device 10, in addition to the power button 11.

A USB (= universal serial bus) cable insertion port 14 is provided on the upper face of the main body device 10, in addition to the stick-type substrate insertion port 13.

The power button 11 is used for instructing the start of heating of the stick-type substrate, for resets, and for instructing Bluetooth (registered trademark) pairing, for example. A reset is performed by a long press (e.g., a press of 5 seconds or more) on the power button 11. BLE (= Bluetooth low energy) is used as Bluetooth in the present embodiment.

The LED lamp 12 is used to notify operating states of the main body device 10, and remaining capacity of a secondary battery, for example. In the present embodiment, a surface of the LED lamp 12 is covered by a light-transmitting material, which enables a user to observe an illumination state of the LED lamp 12.

Operating states include a state of progress of a heating cycle, a state of progress of charging, and errors, for example.

When the state of progress of the heating cycle is being notified, the length of the illuminated part of the LED lamp 12 indicates the remaining usable time. Moreover, the LED lamp 12 flashes slowly when there is little remaining time.

When the state of progress of charging is being notified, the LED lamp 12 flashes during charging, and the length of the flashing part of the LED lamp 12 increases as the amount of stored electricity increases due to charging. Moreover, when charging is complete, the LED lamp 12 turns off or stays in an illuminated state.

When the remaining capacity of the secondary battery is being displayed, the battery remaining capacity is displayed by the length of the illuminated part of the LED lamp 12 at the point in time when the slide cover 20 is opened or at the point in time when the slide cover 20 is closed, for example.

Moreover, the LED lamp 12 flashes when the secondary battery has little remaining capacity. Furthermore, the LED lamp 12 flashes rapidly in a state in which the remaining capacity of the secondary battery will not allow even one unused stick-type substrate to be smoked.

The slide cover 20 is dimensioned to cover approximately half of the upper face. The slide cover 20 operated to the open state completely conceals the USB cable insertion port 14, and the slide cover 20 operated to the closed state completely conceals the stick-type substrate insertion port 13. That is to say, the slide cover 20 has the role of alternately concealing either one of the stick-type substrate insertion port 13 and the USB cable insertion port 14. Fig. 2 shows a state in which the slide cover 20 has been operated to the open state. The stick-type substrate insertion port 13 is an example of an opening through which the substrate is inserted, and the slide cover 20 is an example of an opening and closing portion which opens or closes the opening.

The stick-type substrate used in the present embodiment accommodates a solid aerosol source in a paper tube molded substantially into a cylindrical shape. The shape of the stick-type substrate insertion port 13 is therefore depicted in both fig. 1 and 2 by a circular shape which is generally the same shape as a stick-type substrate. The diameter of an opening part of the stick-type substrate insertion port 13 constitutes the dimension of a stick-type substrate which can be inserted. In other words, the diameter of the stick-type substrate is a dimension that enables the stick-type substrate to be inserted into the stick-type substrate insertion port 13.

The USB cable insertion port 14 is compatible with type C in the present embodiment. However, this does not mean that the shape of the terminal used for charging the secondary battery is limited to type C, or limited to USB. The terminal for a power source cable used for charging the secondary battery may be of another type.

A magnet, for example, is attached to a rear face of the slide cover 20. Meanwhile, a Hall IC is attached to the main body device 10 in a movable range of the slide cover 20.

The Hall IC is a magnetic sensor formed by a Hall element and an operational amplifier, etc., and outputs a voltage commensurate with the intensity of a magnetic field passing across the Hall element.

In the present embodiment, opening and closing of the slide cover 20 is sensed from a change in the voltage output from the Hall IC accompanying sliding of the slide cover 20. That is to say, it is sensed whether the slide cover 20 is at the closed position or the open position.

The aerosol generation device 1 of the present embodiment is sized to be capable of being held by a user in a single hand.

Various types of electronic components required for generating the aerosol are built into the main body device 10. In this sense, the main body device 10 is an example of an electronic device specifically for generating an aerosol. Moreover, in a narrow sense the main body device 10 is referred to as an aerosol generation device.

### <Internal Configuration>

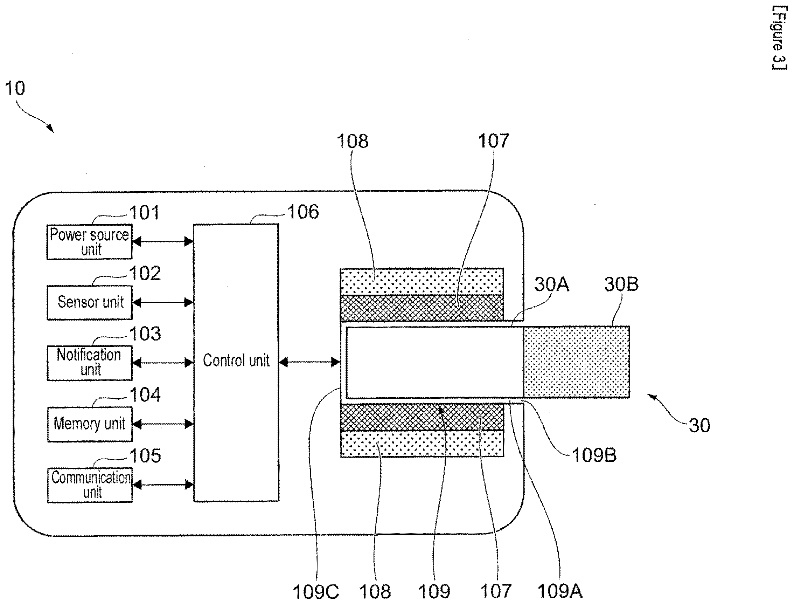

Fig. 3 is a diagram schematically illustrating the internal configuration of the main body device 10. It should be noted that fig. 3 depicts a state in which the stick-type substrate 30 has been fitted into the main body device 10. Furthermore, the internal configuration shown in fig. 3 is intended to illustrate the components provided in the main body device 10 and positional relationships thereof. For this reason, the external appearance of the components, etc. illustrated in fig. 3 does not necessarily match the external appearance diagrams discussed hereinabove.

The main body device 10 is configured by a power source unit 101, a sensor unit 102, a notification unit 103, a memory unit 104, a communication unit 105, a control unit 106, a heating unit 107, a heat insulating portion 108, and a holding portion 109.

As discussed hereinabove, fig. 3 depicts a state in which the stick-type substrate 30 is being held in the holding portion 109. The aerosol is inhaled by the user in this state.

The power source unit 101 is a unit for supplying power to each unit. The power source unit 101 stores power in a secondary battery, for example. A lithium ion secondary battery is used in the present embodiment.

The secondary battery can be charged from an external power source. In the present embodiment, the external power source is assumed to be a mains power source or a mobile battery, for example.

The sensor unit 102 is an electronic component for detecting various types of information relating to the main body device 10.

The sensor unit 102 includes a pressure sensor such as a microphone capacitor, or a flow rate sensor, for example. The sensor unit 102 outputs detected information to the control unit 106. For example, when a change in air pressure or a flow of air accompanying inhalation has been detected, the sensor unit 102 outputs a numerical value representing inhalation of the aerosol by the user to the control unit 106.

The sensor unit 102 is provided in conjunction with a button or switch used for receiving user operations, for example. The button as referred to here includes the power button 11 (see fig. 1) discussed hereinabove. Furthermore, the switch includes the slide cover 20 (see fig. 2) discussed hereinabove.

If an operation by the user is sensed, the sensor 102 outputs the sensing of the operation to the control unit 106.

The sensor unit 102 additionally has a temperature sensor for detecting the temperature of the heating unit 107. The temperature sensor detects the temperature of the heating unit 107 on the basis of an electrical resistance value of a conductive track of the heating unit 107, for example. The detected electrical resistance value is output from the sensor unit 102 to the control unit 106. It should be noted that the control unit 106 calculates the temperature of the heating unit 107 on the basis of the electrical resistance value. In other words, the control unit 106 calculates the temperature of the stick-type substrate 30 which is held in the holding portion 109.

Furthermore, the sensor unit 102 includes a motion sensor that senses a user operation by detecting motion of the main body device 10. The motion sensor may include an acceleration sensor for detecting acceleration of the main body device 10. A capacitive acceleration sensor comprising a fixed electrode and a movable electrode formed from silicon, and a sensor element configured by a spring or the like is illustrated as an example of the acceleration sensor. The acceleration sensor may equally be a piezoresistance or heat-detection type acceleration sensor. Alternatively, the motion sensor may comprise a gyro sensor that detects the angular velocity of the main body device 10. In this case, the sensor unit 102 is an example of a detecting unit which detects motion of the host device.

It should be noted that the timing at which the motion sensor is powered on may be the same as the timing of at which the control unit 106 is powered on. More specifically, since the control unit 106 is powered on when the user cancels a shipment mode of the aerosol generation device 1 and starts using the aerosol generation device 1, it is preferable that the motion sensor is also powered on at this time. Also, since the control unit 106 is powered on even during a sleep mode, the motion sensor is capable of sensing even during the sleep mode.

The notification unit 103 is an electronic component for notifying the user of various types of information relating to the main body device 10. The notification unit 103 includes the LED lamp 12 (see fig. 1), for example. When the power source unit 101 needs to be charged, when the power source unit 101 is in the process of being charged, or when there is an abnormality in the main body device 10, the LED lamp 12 emits light with a different pattern in each case.

The patterns as referred to here include different colors and different timings for illumination/extinguishing, etc. Furthermore, the LED lamp 12 includes a plurality of LEDs. It should be noted that the LED lamp 12 is an example of a light-emitting device and the LEDs are examples of light-emitting elements.

The notification unit 103 may also include another device which is used together with the light emitting device or is used instead of the light emitting device. Devices of this type include display devices for displaying text, images and other information, sound output devices for outputting sound, and vibration devices for causing the main body device 10 to vibrate, etc.

The light emitting device, display device, sound output device and vibration device, etc. are examples of notification units for notifying information.

The notification unit 103 may additionally notify the user that a state in which the aerosol can be inhaled has been achieved. This notification indicates a state in which the temperature of the stick-type substrate 30 heated by means of the heating unit 107 has reached a prescribed temperature.

The memory unit 104 stores various types of information relating to operation of the main body device 10. The memory unit 104 is configured by a non-volatile storage medium such as a flash memory, for example.

Information stored in the memory unit 104 includes an OS (= operating system) and FW (= firmware), and other programs, for example.

Furthermore, the information stored in the memory unit 104 includes information relating to control of electronic components, for example. Information relating to control includes information relating to: remaining capacity and SOH (= state of health) of the secondary battery; and inhalation by the user, such as number of inhalations, times at which inhalation has occurred, and cumulative inhalation time.

The communication unit 105 is a communication interface for implementing communication between the main body device 10 and other devices. The communication unit 105 communicates with other devices by means of a system based on any wired or wireless communication standard. Examples of communication standards as referred to here include wireless LAN (= local area network), serial signal line, Wi-Fi (registered trademark), and Bluetooth (registered trademark).

For example, the communication unit 105 sends the information relating to user inhalation to a smartphone. Furthermore, the communication unit 105 downloads, from a server, update programs and heating profiles defining changes in the temperature of the heating unit 107 in a heating mode.

The control unit 106 functions as an arithmetic processing device and a control device, and controls operations of the main body device 10 in accordance with various programs.

Control signals are sent through signal lines different from a power source line. For example, communication in the main body device 10 employs a serial communication method such as an I2C (= inter-integrated circuit) communication method, an SPI (= serial peripheral interface) communication method, or a UART (= universal asynchronous receiver transmitter) communication method.

The control unit 106 is realized by means of an electronic circuit such as a CPU (= central processing unit), an MCU (= microcontroller unit), an MPU (= microprocessing unit), a GPU (= graphical processing unit), an ASIC (= application-specific integrated circuit), an FPGA (= field programmable gate array), or a DPS (= digital signal processor), for example.

The control unit 106 may also include a ROM (= read only memory) for storing programs and computation parameters, etc., and a RAM (= random access memory) for temporarily storing suitably changing parameters, etc.

The control unit 106 executes various types of processing and control through execution of programs.

The processing and control referred to here include, for example: supply of electricity by the power source unit 101; charging of the power source unit 101; detection of information by the sensor unit 102; notification of information employing the notification unit 103; writing of information to the memory unit 104 or reading of information from the memory unit 104; and sending/receiving of information employing the communication unit 105.

The control unit 106 additionally controls processing, etc. based on input of information to the electronic components and information output from the electronic components.

The holding portion 109 is a substantially cylindrical container. In the present embodiment, a space inside the holding portion 109 defined by an inner wall and a bottom face will be referred to as an internal space 109A. The internal space 109A is substantially columnar.

An opening 109B allowing the internal space 109A to communicate with the exterior is provided in the holding portion 109. The stick-type substrate 30 is inserted into the internal space 109A from the opening 109B. The opening 109B as referred to here corresponds to the stick-type substrate insertion port 13 in fig. 1. The stick-type substrate 30 is inserted until a tip end thereof touches a bottom portion 109C.

The stick-type substrate 30 is only partially accommodated in the internal space 109A. A state in which the stick-type substrate 30 is accommodated in the internal space 109A will be referred to as the stick-type substrate 30 being held in the internal space 109A.

The inner diameter of at least part of the holding portion 109 in an axial direction thereof is formed so as to be smaller than the outer diameter of the stick-type substrate 30.

An outer circumferential surface of the stick-type substrate 30 inserted into the internal space 109A is therefore subjected to pressure from the inner wall of the holding portion 109. The stick-type substrate 30 is held in the internal space 109A by means of this pressure.

The holding portion 109 also has a function of defining a flow path for air passing through the stick-type substrate 30. An air inflow hole, which is an inlet for air into the flow path, is disposed in the bottom portion 109C, for example. Moreover, the opening 109B serves as an air outflow hole, which is an outlet for the air.

In the present embodiment, only part of the stick-type substrate 30 is held in the holding portion 109, with the remainder protruding outside from an enclosure. The part which is held in the holding portion 109 will be referred to below as a substrate portion 30A, and the part protruding from the enclosure will be referred to below as a mouthpiece portion 30B.

The aerosol source is accommodated in at least the substrate portion 30A. The aerosol source is a substance which is atomized by heating so as to generate an aerosol.

The aerosol source includes shredded tobacco, and also processed products obtained by molding a tobacco raw material into a granular form, a sheet form or a powder form, or other tobacco-derived substances.

In addition, the aerosol source may also include non-tobacco-derived substances produced from plants other than tobacco, such as mint or herb. The aerosol source may include a flavoring component such as menthol, for example.

When the main body device 10 is a medical inhaler, the aerosol source may include a drug to be inhaled by a patient. It should be noted that the aerosol source is not limited to a solid, and may equally be a polyhydric alcohol such as glycerol or propylene glycol, or may be a liquid such as water, for example.

At least part of the mouthpiece portion 30B is held in the user's mouth during inhalation.

When the user inhales with the mouthpiece portion 30B held in their mouth, air flows into the internal space 109A from the air inflow hole. The air that has flowed in reaches the user's mouth after passing through the internal space 109A and the substrate portion 30A. The air reaching the user's mouth contains the aerosol generated by the substrate portion 30A.

The heating unit 107 is formed by a heater or other heat-generating element. The heating unit 107 is formed by any material such as a metal or polyimide. The heating unit 107 is constructed in the form of a film, for example, and is fitted to the outer circumferential surface of the holding portion 109.

The aerosol source contained in the stick-type substrate 30 is heated and atomized by the heat generated by the heating unit 107. The atomized aerosol source is mixed with air, etc., and an aerosol is generated.

In fig. 3, the outer circumferential region of the stick-type substrate 30 is initially heated, with the range of heating steadily moving toward the center.

Atomization of the aerosol source therefore starts from the outer circumferential region of the stick-type substrate 30 and steadily moves toward the center.

The heating unit 107 generates heat by means of electrical supply from the power source unit 101. Electrical supply to the heating unit 107 is permitted when a prescribed user operation has been sensed by means of the sensor unit 102, for example. The prescribed user operation as referred to here includes operation of the slide cover 20 (see fig. 2) and/or of the power button 11 (see fig. 1).

The heating unit 107 heats the stick-type substrate 30, which is the aerosol source, in accordance with a heating profile stored in the memory unit 104. The heating profile is a data file defining a change over time in a target temperature after the start of heating. The heating profile is an example of a control sequence that defines the heating. Therefore, the heating unit 107 is an example of a heating unit which heats a substrate containing an aerosol source by means of electrical supply from a power source, in accordance with a control sequence. Furthermore, a plurality of heating profiles may be stored in the memory unit 104. Therefore, the heating unit 107 is an example of a heating unit which heats the substrate in accordance with any of a plurality of control sequences.

Moreover, inhalation by the user becomes possible when the temperature of the stick-type substrate 30 heated by means of the heating unit 107 reaches a prescribed temperature. Inhalation of the aerosol by the user is sensed by means of the flow rate sensor, etc. in the sensor unit 102 and is saved in the memory unit 104.

Electrical supply to the heating unit 107 is stopped when a prescribed user operation is subsequently sensed. The prescribed user operation includes an operation to close the slide cover 20.

It should be noted that, even if the prescribed user operation is not sensed, electrical supply to the heating unit 107 is stopped when a heating time defined in the heating profile has expired.

It is additionally possible to adopt a method in which electricity is supplied to the heating unit 107 while inhalation by the user is detected, and electrical supply to the heating unit 107 is stopped when inhalation by the user is no longer detected.

Furthermore, in the example of fig. 3, the heating unit 107 is disposed at the outer circumferential portion of the stick-type substrate 30, but it is equally possible for the heating unit 107 to be a blade-like metal piece which is inserted into the stick-type substrate 30, or for the heating unit 107 to be a metal piece built into the stick-type substrate 30. When a metal piece acting as the heating unit 107 is built into the stick-type substrate 30, an induction heating coil should be arranged around the holding portion 109.

The heat insulating portion 108 is a member for reducing propagation of heat generated by the heating unit 107 to the surrounding area. The heat insulating portion 108 is therefore disposed so as to cover at least the outer circumferential surface of the heating unit 107.

For example, the heat insulating portion 108 is configured by a vacuum insulating material or an aerogel insulating material, etc. A vacuum insulating material is a heat insulating material in which a state of high vacuum is created by wrapping glass wool and silica (silicon powder), etc. in a resin film, for example, so that heat conduction by gas is as close as possible to zero.

### <Detection of user motion>

Sensing of a user operation by the sensor unit 102 will now be described. It should be noted that in the present embodiment, a double-tap operation on the aerosol generation device 1 and a shake operation on the aerosol generation device 1 will be described, as examples of user operations.

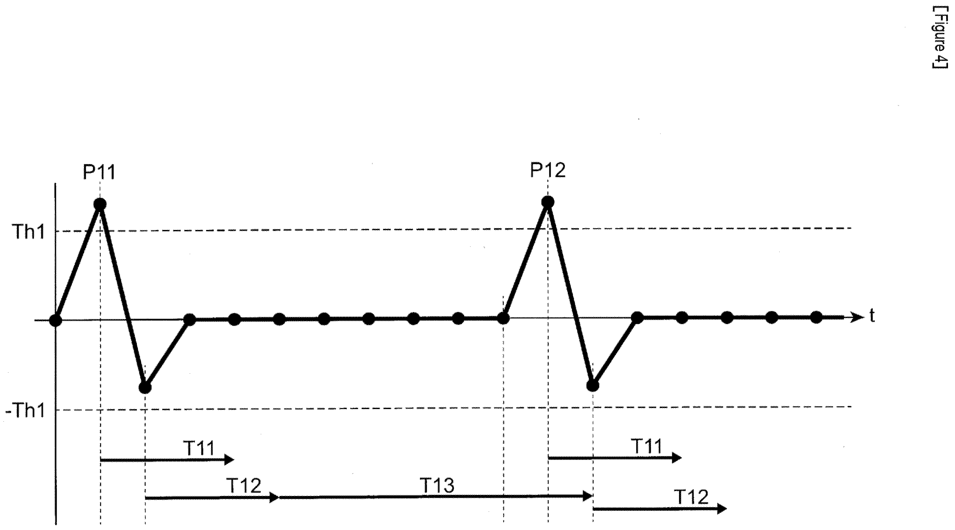

Fig. 4 is a diagram illustrating a method for sensing a double-tap operation by means of the sensor unit 102. The sensor unit 102 senses a double-tap operation by detecting acceleration of the aerosol generation device 1 and performing the following processing on the basis of this acceleration.
(1) A period T11 starts when the acceleration exceeds an upper limit threshold Th1 or falls below a lower limit threshold (-Th1).
(2) If the acceleration exceeds the upper limit threshold Th1 in (1), a first tap is sensed if the acceleration falls below the upper limit threshold Th1 within the period T11, and if the acceleration falls below the lower limit threshold (-Th1) in (1), the first tap is sensed if the acceleration exceeds the lower limit threshold (-Th1) within the period T11. In the drawing, the first tap is sensed at point P11.
(3) A period T12 starts after the first tap is sensed. In other words, processing similar to that for preventing chatter is performed during a period in which no tap is sensed.
(4) A period T13 starts from the moment the period T12 ends.
(5) A second tap is sensed if the tap detection in (1) and (2) occurs again within the period T13. In the drawing, the second tap is sensed at point P12. A double-tap operation is thereby sensed.

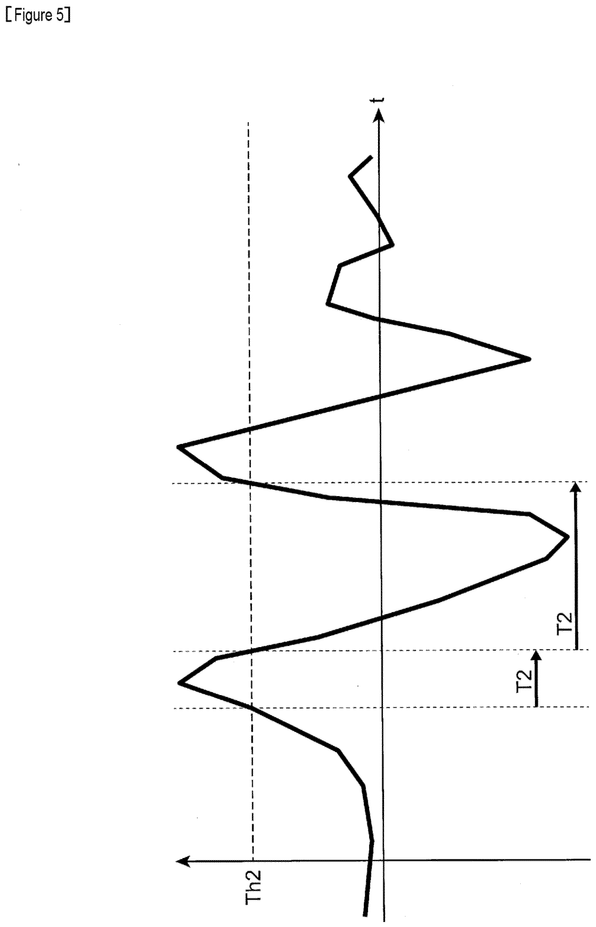

Fig. 5 is a diagram illustrating a method for sensing a shake operation by means of the sensor unit 102. The sensor unit 102 senses a shake operation by detecting acceleration of the aerosol generation device 1 and performing the following processing on the basis of this acceleration.
(1) Counting for a period T2 starts when the acceleration exceeds a threshold Th2.
(2) Counting for the period T2 starts again if the acceleration falls below the threshold Th2 within the period T2.
(3) A shake operation is sensed if the acceleration exceeds the threshold Th2 within the period T2.

It should be noted that the control unit 106 only needs to pass the acceleration threshold information and detection period information to the sensor unit 102, and the processing for detecting the user operations illustrated in fig. 4 and fig. 5 is assumed to be completed within the sensor unit 102.

Furthermore, if the sensor unit 102 erroneously senses the user operation, the heating profile may be switched at a timing not intended by the user, and therefore a mechanism for preventing erroneous sensing is required.

As a mechanism for preventing such erroneous sensing, it is conceivable, for example, to collect threshold data for the double-tap operation and the shake operation, etc., for a certain number of users, and adopt this threshold data in the sensor unit 102 of all aerosol generation devices 1 of a particular model. Moreover, the configuration may be such that the threshold data are not adjusted for each user if the model of the aerosol generation device 1 being used is the same, or such that the threshold data are adjusted for each user even though the model of the aerosol generation device 1 being used is the same.

### <Outline of operation>

Switching of the heating profile used for heating in the aerosol generation device 1 will now be described.

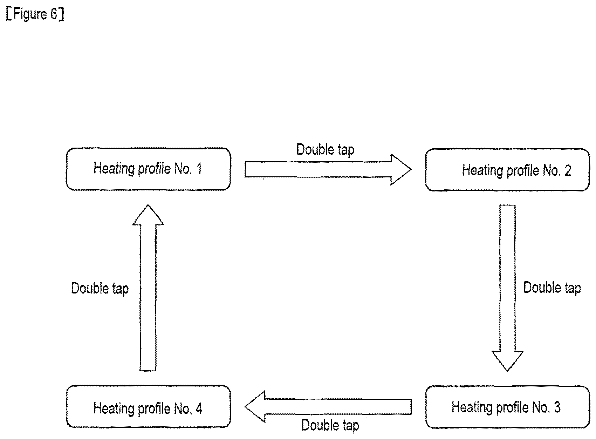

Fig. 6 is a diagram illustrating a first method for switching the heating profile. In this first switching method, when the user performs a prescribed operation, the aerosol generation device 1 switches between the heating profiles stored in the memory unit 104 in accordance with a predetermined order. Here, the prescribed operation will be described taking the double-tap operation on the aerosol generation device 1 as an example, but is not limited to this. The prescribed operation may equally be a shake operation on the aerosol generation device 1, etc.

In the drawing, in the initial state it is assumed that heating profile No. 1 is selected as the heating profile to be used for heating. In this state, if the user performs a double-tap operation on the aerosol generation device 1, the control unit 106 switches the heating profile to be used for heating to heating profile No. 2. If the user subsequently performs a double-tap operation on the aerosol generation device 1, the control unit 106 switches the heating profile to be used for heating to heating profile No. 3. If the user subsequently performs a double-tap operation on the aerosol generation device 1, the control unit 106 switches the heating profile to be used for heating to heating profile No. 4. Moreover, if the user performs a double-tap operation on the aerosol generation device 1, the control unit 106 returns the heating profile to be used for heating to heating profile No. 1.

In this case, the motion of the aerosol generation device 1 due to the prescribed operation of the user is an example of a specific motion. Furthermore, the control unit 106 is an example of a control unit which performs control to switch a currently selected control sequence to another control sequence when a specific motion is detected by the detecting unit. Furthermore, the control unit 106 is an example of a control unit which performs control to select the other control sequence from among a plurality of control sequences. Yet further, the control unit 106 is an example of a control unit which performs control to select the other control sequence in accordance with a predetermined order of the plurality of control sequences

Here, the configuration may be such that, by connecting the aerosol generation device 1 to a smartphone, the order of the heating profiles can be changed via an application on the smartphone. However, even if the order of the heating profiles can be changed in this way, the number of double-tap operations required to switch to the intended heating profile may increase. For example, in fig. 6, if the user wishes to switch to heating profile No. 4 in a state in which heating profile No. 1 is set, and if neither of heating profiles No. 2 and No. 3 has been stored, a single double-tap on the aerosol generation device 1 is sufficient. However, if heating profiles No. 2 and No. 3 have both been stored, the aerosol generation device 1 needs to be double-tapped three times. Accordingly, a second method for switching between heating profiles, which does not require a large number of prescribed operations to switch to the intended heating profile, can be considered.

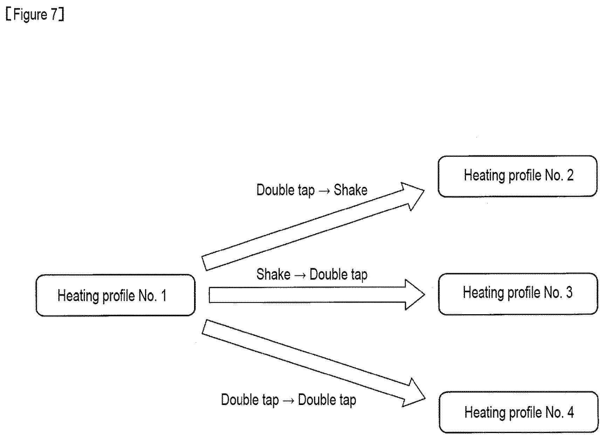

Fig. 7 is a diagram illustrating a second method for switching the heating profile. In this second switching method, when the user performs an operation, the aerosol generation device 1 switches between the heating profiles stored in the memory unit 104 in accordance with the type of the operation. Here, the operation will be described taking a combined operation of the double-tap operation and the shake operation on the aerosol generation device 1 as an example, but is not limited to this. The operation may be a single operation comprising any one of a double-tap operation, a shake operation or another operation on the aerosol generation device 1, or may be a combined operation of any two or more of said operations.

In the drawing, in the initial state it is assumed that heating profile No. 1 is selected as the heating profile to be used for heating. In this state, if the user performs a double-tap operation followed by a shake operation on the aerosol generation device 1, the control unit 106 switches the heating profile to be used for heating to heating profile No. 2. Further, if the user performs a shake operation followed by a double-tap operation on the aerosol generation device 1, the control unit 106 switches the heating profile to be used for heating to heating profile No. 3. Furthermore, if the user performs a double-tap operation on the aerosol generation device 1 twice in succession, the control 106 switches the heating profile to be used for heating to heating profile No. 4. Moreover, in order to return again from the switching target heating profile to heating profile No. 1, the operation performed to switch to the switching target heating profile should be performed again, for example.

In this case, the motion of the aerosol generation device 1 due to the operation of the user is an example of a specific motion. Furthermore, the control unit 106 is an example of a control unit which performs control to switch a currently selected control sequence to another control sequence when a specific motion is detected by the detecting unit. Furthermore, the control unit 106 is an example of a control unit which performs control to select the other control sequence from among a plurality of control sequences. Yet further, the control unit 106 is an example of a control unit which performs control to select the other control sequence in accordance with the type of the specific motion detected by the detecting unit.

Moreover, when the heating profile is switched, the notification unit 103 may notify information specifying the switching target heating profile. In this case, the notification portion 103 is an example of a notification unit which notifies information specifying the other control sequence.

For example, if the notification unit 103 is a vibrating device, the information specifying the switching target heating profile may be notified by causing the main body device 10 to vibrate a number of times corresponding to the switching target heating profile number. In this case, the notification unit 103 is an example of a notification unit which notifies the information specifying the other control sequence by vibrating a number of times corresponding to the other control sequence.

Alternatively, if the notification unit 103 is the LED lamp 12, the information specifying the switching target heating profile may be notified by turning on the number of LEDs corresponding to the switching target heating profile number. In this case, the notification unit 103 is an example of a notification unit which notifies the information specifying the other control sequence by causing a number of light-emitting elements corresponding to the other control sequence to emit light.

Also, in the aerosol generation device 1, the control unit 106 may be configured such that the heating profile is not switched if a prescribed condition is met. In this case, the control unit 106 is an example of a control unit which performs control such that the control sequence is not switched if a prescribed condition is met, even if the specific motion is detected by the detecting unit.

For example, the prescribed condition may be that the slide cover 20 is open. This is because if the slide cover 20 is open, it is assumed that heating is being performed in accordance with a heating profile. In this case, the condition that the slide cover 20 is open is an example of the condition that the opening is opened by the opening and closing portion.

Alternatively, the prescribed condition may be that the slide cover 20 is open and the user has performed a predefined operation. In this case, the predetermined operation is a double-tap operation, for example. For example, when the slide cover 20 is open and smoking is taking place, a double-tap operation is highly likely to be an erroneous operation. In this case, the condition that the slide cover 20 is open and the user has performed a predefined operation is an example of the condition that the opening is opened by the opening and closing portion, and the specific motion detected by the detecting unit is a predefined motion.

Alternatively, the prescribed operation may be the condition that the aerosol generation device 1 is performing BLE communication. This is because if the aerosol generation device 1 is performing BLE communication, it is assumed that a heating profile is being transmitted or received.

### <Details of operation>

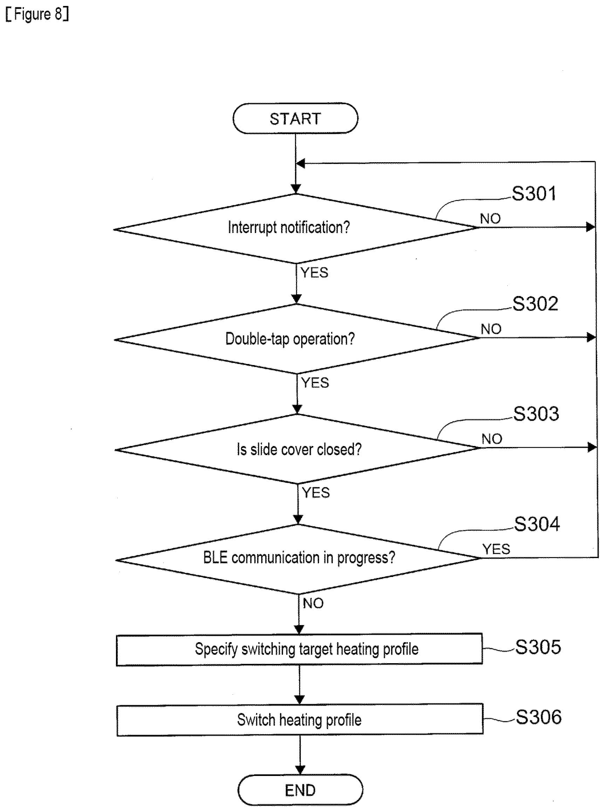

Fig. 8 is a flowchart showing a first operation example performed when the aerosol generation device 1 switches between heating profiles. Here, a case in which the heating profile is switched as in the example illustrated in fig. 6 will be described by way of example.

As illustrated in the drawing, in the aerosol generation device 1, the control unit 106 first determines whether an interrupt notification has been received (step 301).

If it is determined in step 301 that no interrupt notification has been received, the control unit 106 repeats step 301. Meanwhile, if it is determined in step 301 that an interrupt notification has been received, the control unit 106 reads the value of a status register of the sensor unit 102 and determines, on the basis of the value, whether or not the user has performed a double-tap operation on the aerosol generation device 1 (step 302).

If it is determined in step 302 that the user has not performed a double-tap operation on the aerosol generation device 1, the control unit 106 returns the processing to step 301. Meanwhile, if it is determined in step 302 that the user has performed a double-tap operation on the aerosol generation device 1, the control unit 106 determines whether or not the slide cover 20 is closed (step 303).

If it is determined in step 303 that the slide cover 20 is not closed, the control unit 106 returns the processing to step 301. Meanwhile, if it is determined in step 303 that the slide cover 20 is closed, the control unit 106 determines whether or not BLE communication is in progress (step 304).

If it is determined in step 304 that BLE communication is in progress, the control unit 106 returns the processing to step 301. Meanwhile, if it is determined in step 304 that BLE communication is not in progress, the control unit 106 specifies the switching target heating profile (step 305). For example, if the heating profile next in order to the currently selected heating profile is stored, the control unit 106 may specify the heating profile next in order as the switching target heating profile. Furthermore, if no heating profile placed in order after the currently selected heating profile is stored, the control unit 106 may specify the currently selected heating profile as the switching target heating profile.

The control unit 106 then switches the currently selected heating profile to the heating profile specified in step 305 (step 306). At this time, the notification unit 103 may vibrate the main body device 10 a number of times corresponding to the switching target heating profile number or turn on the number of LEDs corresponding to the switching target heating profile number.

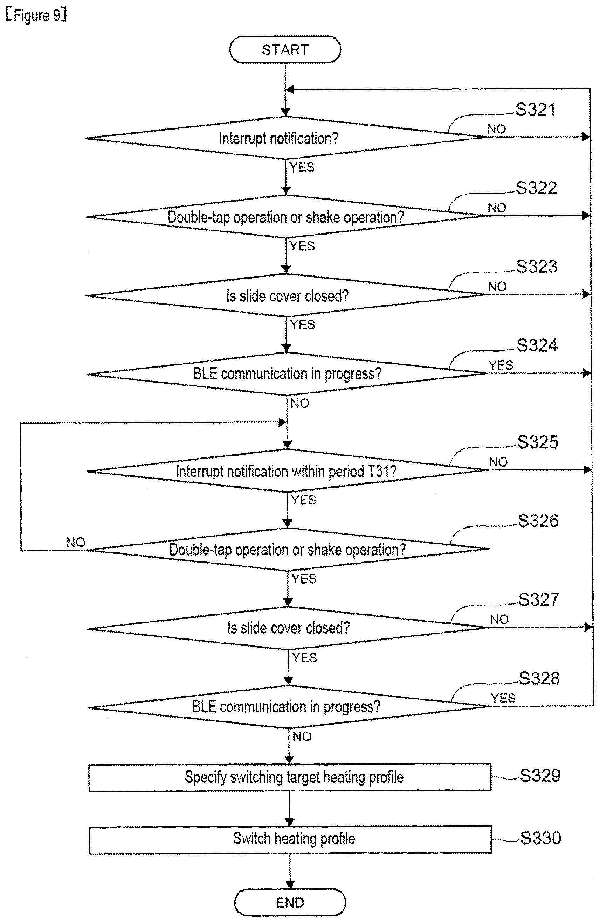

Fig. 9 is a flowchart showing a second operation example performed when the aerosol generation device switches between heating profiles. Here, a case in which the heating profile is switched as in the example illustrated in fig. 7 will be described by way of example.

As illustrated in the drawing, in the aerosol generation device 1, the control unit 106 first determines whether an interrupt notification has been received (step 321).

If it is determined in step 321 that no interrupt notification has been received, the control unit 106 repeats step 321. Meanwhile, if it is determined in step 321 that an interrupt notification has been received, the control unit 106 reads the value of the status register of the sensor unit 102 and determines, on the basis of the value, whether or not the user has performed a double-tap operation or a shake operation on the aerosol generation device 1 (step 322).

If it is determined in step 322 that the user has not performed a double-tap operation or a shake operation on the aerosol generation device 1, the control unit 106 returns the processing to step 321. Meanwhile, if it is determined in step 322 that the user has performed a double-tap operation or a shake operation on the aerosol generation device 1, the control unit 106 determines whether or not the slide cover 20 is closed (step 323).

If it is determined in step 323 that the slide cover 20 is not closed, the control unit 106 returns the processing to step 321. Meanwhile, if it is determined in step 323 that the slide cover 20 is closed, the control unit 106 determines whether or not BLE communication is in progress (step 324).

If it is determined in step 324 that BLE communication is in progress, the control unit 106 returns the processing to step 321. Meanwhile, if it is determined in step 324 that BLE communication is not in progress, the control unit 106 determines whether or not an interrupt notification has been received again within a period T31 since it was determined in step 321 that an interrupt notification was received (step 325).

If it is determined in step 325 that no interrupt notification has been received within the period T31, the control unit 106 returns the processing to step 321. Meanwhile, if it is determined in step 325 that an interrupt notification has been received within the period T31, the control unit 106 reads the value of the status register of the sensor unit 102 and determines, on the basis of the value, whether or not the user has performed a double-tap operation or a shake operation on the aerosol generation device 1 (step 326).

If it is determined in step 326 that the user has not performed a double-tap operation or a shake operation on the aerosol generation device 1, the control unit 106 returns the processing to step 325. Meanwhile, if it is determined in step 326 that the user has performed a double-tap operation or a shake operation on the aerosol generation device 1, the control unit 106 determines whether or not the slide cover 20 is closed (step 327).

If it is determined in step 327 that the slide cover 20 is not closed, the control unit 106 returns the processing to step 321. Meanwhile, if it is determined in step 327 that the slide cover 20 is closed, the control unit 106 determines whether or not BLE communication is in progress (step 328).

If it is determined in step 328 that BLE communication is in progress, the control unit 106 returns the processing to step 321. Meanwhile, if it is determined in step 328 that BLE communication is not in progress, the control unit 106 specifies the switching target heating profile (step 329). For example, the control unit 106 may specify the switching target heating profile in accordance with a combination of the operation determined in step 322 and the operation determined in step 326. Furthermore, in the example of fig. 7, if there is no switching target heating profile corresponding to the combination of operations, such as when both the operation determined in step 322 and the operation determined in step 326 are shake operations, the control unit 106 may return the processing to step 325.

The control unit 106 then switches the currently selected heating profile to the switching target heating profile specified in step 329 (step 330). At this time, the notification unit 103 may vibrate the main body device 10 a number of times corresponding to the switching target heating profile number or turn on the number of LEDs corresponding to the switching target heating profile number.

### <Advantageous Effects>

The aerosol generation device 1 according to the present embodiment is configured to switch between control sequences that define heating in response to user operations. As a result, in the present embodiment, it is possible to switch control sequences easily.

### «Other Embodiments»

(1) Embodiments of the present disclosure were described above, but the technical scope of the present disclosure is not limited to the scope disclosed in the embodiments above. It will be obvious from the disclosure of the claims that the technical scope of the present disclosure also includes various modifications or improvements made to the embodiments above.
(2) The embodiments above described a case in which the aerosol source is a solid, but the aerosol source may equally be a liquid. When the aerosol source is a liquid, a system is adopted in which the aerosol source is guided to a narrow tube known as a wick by using the capillary phenomenon, and a coil wound around the wick is heated to thereby vaporize the aerosol source.
(3) The embodiments discussed hereinabove described an aerosol generation device which generates an aerosol by heating a solid aerosol source, but the aerosol generation device may equally generate an aerosol by separately heating each of a solid aerosol source and a liquid aerosol source. An aerosol generation device of this type is also referred to as a hybrid aerosol generation device.

### «Summary»

It should be noted that the present disclosure includes the following features.
(1) An aerosol generation device comprising: a heating unit which heats a substrate containing an aerosol source by means of electrical supply from a power source, in accordance with a control sequence; a detecting unit which detects motion of the host device; and a control unit which performs control to switch a currently selected control sequence to another control sequence when a specific motion is detected by the detecting unit.
(2) The aerosol generation device as disclosed in (1), wherein the control unit performs control to select the other control sequence from among a plurality of control sequences.
(3) The aerosol generation device as disclosed in (2), wherein the control unit performs control to select the other control sequence in accordance with a predetermined order of the plurality of control sequences.
(4) The aerosol generation device as disclosed in (2), wherein the control unit performs control to select the other control sequence in accordance with the type of the specific motion detected by the detecting unit.
(5) The aerosol generation device as disclosed in (1), additionally comprising a notification unit which notifies information specifying the other control sequence.
(6) The aerosol generation device as disclosed in (5), wherein the notification unit notifies the information specifying the other control sequence by vibrating a number of times corresponding to the other control sequence.
(7) The aerosol generation device as disclosed in (5), wherein the notification unit notifies the information specifying the other control sequence by causing a number of light-emitting elements corresponding to the other control sequence to emit light.
(8) The aerosol generation device as disclosed in (1), wherein the control unit performs control such that the control sequence is not switched if a prescribed condition is met, even if the specific motion is detected by the detecting unit.
(9) The aerosol generation device as disclosed in (8), additionally comprising an opening and closing portion which opens or closes an opening through which the substrate is inserted, wherein the prescribed condition is that the opening is opened by the opening and closing portion.
(10) The aerosol generation device as disclosed in (8), additionally comprising an opening and closing portion which opens or closes an opening through which the substrate is inserted, wherein the prescribed condition is that the opening is opened by the opening and closing portion, and the specific motion detected by the detecting unit is a predefined motion.

### REFERENCE SIGNS LIST

1... Aerosol generation device; 10... Main body device; 11... Power button; 12... LED lamp; 13... Stick-type substrate insertion port; 14... USB cable insertion port; 20... Slide cover; 101... Power source unit; 102... Sensor unit; 103... Notification unit; 104... Memory unit; 105... Communication unit; 106... Control unit; 107... Heating unit; 108... Heat insulating portion; 109... Holding portion; 30... Stick-type substrate

## Claims

1. An aerosol generation device comprising: a heating unit which heats a substrate containing an aerosol source by means of electrical supply from a power source, in accordance with a control sequence;
a detecting unit which detects motion of the host device; and
a control unit which performs control to switch a currently selected control sequence to another control sequence when a specific motion is detected by the detecting unit.

2. The aerosol generation device as claimed in claim 1, wherein the control unit performs control to select the other control sequence from among a plurality of control sequences.

3. The aerosol generation device as claimed in claim 2, wherein the control unit performs control to select the other control sequence in accordance with a predetermined order of the plurality of control sequences.

4. The aerosol generation device as claimed in claim 2, wherein the control unit performs control to select the other control sequence in accordance with the type of the specific motion detected by the detecting unit.

5. The aerosol generation device as claimed in claim 1, additionally comprising a notification unit which notifies information specifying the other control sequence.

6. The aerosol generation device as claimed in claim 5, wherein the notification unit notifies the information specifying the other control sequence by vibrating a number of times corresponding to the other control sequence.

7. The aerosol generation device as claimed in claim 5, wherein the notification unit notifies the information specifying the other control sequence by causing a number of light-emitting elements corresponding to the other control sequence to emit light.

8. The aerosol generation device as claimed in claim 1, wherein the control unit performs control such that the control sequence is not switched if a prescribed condition is met, even if the specific motion is detected by the detecting unit.

9. The aerosol generation device as claimed in claim 8, additionally comprising an opening and closing portion which opens or closes an opening through which the substrate is inserted, wherein
the prescribed condition is that the opening is opened by the opening and closing portion.

10. The aerosol generation device as claimed in claim 8, additionally comprising an opening and closing portion which opens or closes an opening through which the substrate is inserted, wherein
the prescribed condition is that the opening is opened by the opening and closing portion, and the specific motion detected by the detecting unit is a predefined motion.
